# EUROPEAN PATENT SPECIFICATION

(11) **EP 4 542 629 B1**
(45) Date of publication and mention of the grant of the patent: **17.06.2026**
(21) Application number: 24207010.0
(22) Date of filing: 16.10.2024
(51) Int. Cl.: H10W 99/00, H10W 74/10, H10W 70/40

(54) **METHOD OF MANUFACTURING SEMICONDUCTOR DEVICES AND CORRESPONDING SEMICONDUCTOR DEVICE**
VERFAHREN ZUR HERSTELLUNG VON HALBLEITERBAUELEMENTEN UND ZUGEHÖRIGES HALBLEITERBAUELEMENT
PROCÉDÉ DE FABRICATION DE DISPOSITIFS SEMI-CONDUCTEURS ET DISPOSITIF SEMI-CONDUCTEUR CORRESPONDANT

(30) Priority: 17.10.2023 IT 202300021597
(43) Date of publication of application: 23.04.2025
(73) Proprietor: STMicroelectronics International N.V., 1228 Plan-les-Ouates, Geneva (CH)
(72) Inventor: CATALANO, Guendalina, 20125 Milano (IT); MELLINA GOTTARDO, Alessandro, 20139 Milano (IT); ARRIGONI, Alberto, 22030 Eupilio (Como) (IT)
(74) Representative: Buzzi, Notaro & Antonielli d'Oulx S.p.A.

(56) References cited:
- JP-A- 2000 260 911
- JP-A- 2004 104 155
- JP-A- 2012 244 038
- US-A1- 2007 126 092
- US-A1- 2013 075 881
- US-B2- 11 264 309

## Description

### Technical field

The description relates to semiconductor devices.

One or more embodiments can be applied to semiconductor devices including integrated circuits (ICs), for instance.

### Background

Current manufacturing processes of (integrated circuit, IC) semiconductor devices comprise molding an insulating molding compound onto the devices to provide an insulating encapsulation thereto.

Resin leaks or flashes at the bottom surface of the die pad that can undesirably result from the molding step and may cause inadequate plating of the bottom surface of the die pad.

For instance, resin flashes have been observed to cause formation of so-called "tin islands" at the periphery of the bottom surface of the die pad; these lumps of solder material may detach from the die pad and possibly cause undesired short circuits between the leads.

Resin flashes may be removed via de-flashing processes such as dry de-flashing via laser ablation, for instance, or chemical de-flashing.

However, conventional de-flashing processes come with the drawback of undesirably promoting delamination between the metallic material (copper, for instance) of the leadframe and the electrically insulating encapsulation.

Document US 2007126092 A1 discloses a package to encase a semiconductor package that is manufactured by the following steps. First, an electrically conductive frame is provided. The frame has a plurality of leadframes arranged in a matrix with each leadframe having a plurality of spaced leads extending outwardly from a central aperture. The electrically conductive frame further includes a plurality of connecting bars joining outer end portions of adjacent ones of the leadframes. Second, a groove is formed in the connecting bars to form a reduced thickness portion between the outer end portions of adjacent ones of the leadframes. Third, a semiconductor device is electrically coupled to inner portions of said leads. Fourth, the frame and the semiconductor devices are encapsulated in a molding compound. Finally, the molding compound and the frame are cut along the grooves to form singulated semiconductor packages having outer lead portions with a height greater than the height of the reduced thickness portion.

Document JP 2000260911 A discloses a device having a rear surface heat dissipation semiconductor resin sealed package, and a manufacturing method thereof, in which the mold resin is prevented surely from being stripped off from a rear surface heat sink or a semiconductor element. A semiconductor element is mounted on a rear surface heat sink disposed on the mounting board and a lead terminal is disposed on the side of the rear surface heat sink. The rear surface heat sink, the semiconductor element and the lead terminal are coated with a mold resin and the rear surface heat sink is exposed. A bend directing toward the inside of the mold resin is provided at the end of the rear surface heat sink and a recess is made at the base point of the bend on the side opposite to the mounting board.

Document JP 2004104155 A discloses a method to provide a semiconductor device with improved adhesive strength between a die pad and sealing resin and improved moisture resistance, and a manufacturing method thereof. The semiconductor device is provided with a plurality of protrusions at side faces of the die pad, and a lead frame is processed so that the protrusions are bent to the mounting surface side for a semiconductor element. Further, with the semiconductor element mounted on the mounting surface and with the exposing surface of the die pad exposed, the semiconductor element, the protrusions, and inner leads etc. are sealed with the sealing resin. The protrusions and their connecting parts are engaged with the sealing resin, resulting in improvement of adhesion. During mounting, the deformation of the die pad is small, so after mounting, the good moisture resistance can also be maintained.

Documents such as JP 2012244038 A, US 11264309 B2, US 2013075881 A1, US 20200273813 A1, US 20110266662 A1, JP 2017079229 A, US 20220093494 A1, US 10366943 B2, US 10784186 B2, US 7262491 B2 and US 20230187296 A1 provide background information in the related technological area.

### Object and summary

An object of one or more embodiments is to overcome the drawbacks discussed in the foregoing.

According to one or more embodiments, that object is achieved via a method having the features set forth in the claims that follow.

One or more embodiments relate to a corresponding (integrated circuit) semiconductor device.

The claims are an integral part of the technical teaching provided in respect of the embodiments.

In solutions as described herein laser beam energy is applied to the bottom surface of a die pad to form therein a recessed portion that is subsequently filled with electrically insulating molding compound.

In solutions as described herein, a roughened surface is formed at the recessed portion of the die pad that enhances adhesion between the molding compound and the die pad.

In solutions as described herein, an adhesion promoter layer possibly provided at the bottom surface of the die pad is removed at the recessed portion thereof via laser ablation, prior to molding an electrically insulating encapsulation.

Solutions as described herein may advantageously be applied to (integrated circuit) semiconductor devices provided with an exposed pad quad flat package (QFP), for instance.

### Brief description of the figures

One or more embodiments will now be described, by way of example only, with reference to the annexed figures, wherein:
Figure 1 is a cross-sectional view of a semiconductor device to which embodiments of the present description can apply,
Figure 2 is exemplary of a possible aspect of a portion of a back or bottom surface of a device as illustrated in Figure 1,
Figure 3 is an enlarged view corresponding to the portion of Figure 2 indicated by the arrow III,
Figure 4 is an enlarged view of the portion of Figure 1 indicated by the arrow IV,
Figures 5A and 5B are cross-sectional views of the same portion of a semiconductor device illustrative of processing steps according to embodiments of the present description, and
Figure 6 is a cross-sectional view illustrative of possible embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

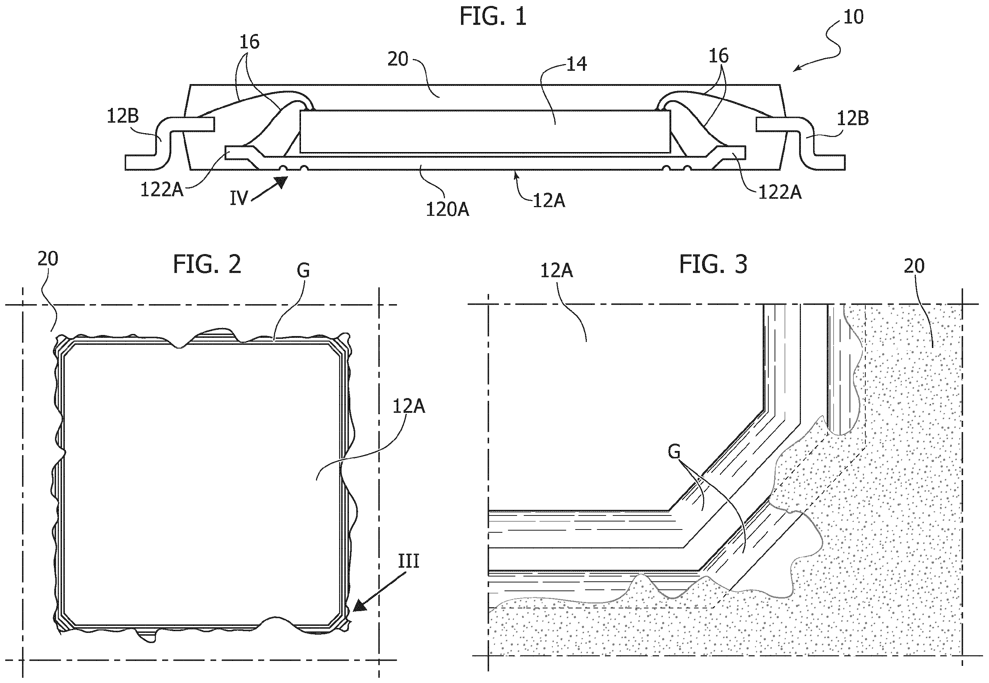

Figure 1 is a cross-sectional view illustrative of an (integrated circuit, IC) semiconductor device 10 provided with a quad flat package (QFP).

The exemplary device 10 illustrated in Figure 1 comprises:
a semiconductor die/chip 14 (the terms chip/s and die/dice are herein regarded as synonymous) attached at the top/front surface of a die pad 12A in a leadframe, and
an array of leads 12B arranged around the die pad 12A having the die 14 mounted thereon.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

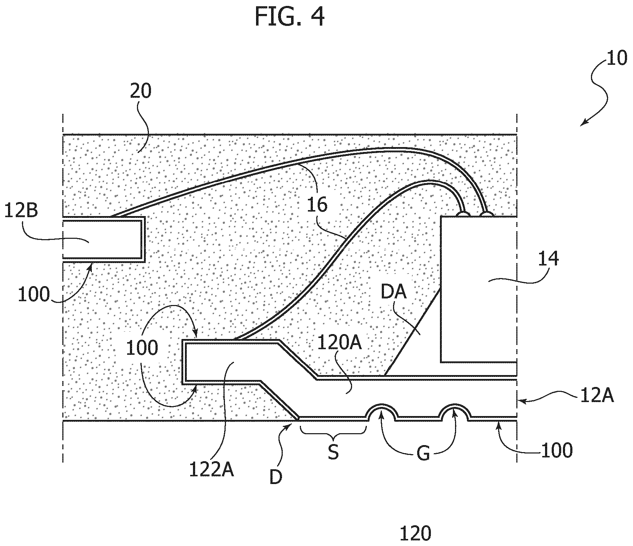

Essentially, a leadframe comprises an array of electrically-conductive formations (or leads 12B) that from an outline location extend inwardly in the direction of a semiconductor chip or die 14 thus forming an array of electrically-conductive formations from a die pad 12A configured to have at least one (integrated circuit - IC) semiconductor die attached thereon. This may be via conventional means such as a die attach adhesive (a die attach film, for instance, as illustrated in Figure 4 and referenced therein with the reference DA).

As exemplified in Figure 1, a semiconductor device 10 may be provided with a die pad 12A having a (central) die mounting region 120A and a raised rim 122A around the die mounting region giving the die pad 12A a vat-like shape.

As illustrated herein by way of example, an (integrated circuit) semiconductor device such as the device 10 may also comprise electrically conductive formations 16 (wires, for instance) that couple the semiconductor die 14 to the leads (outer pads) 12B (providing input/output signals, for instance) and/or to the die pad 12A (providing a ground level, for instance) .

An electrically insulating molding compound 20 (an epoxy resin, for instance) is molded onto the assembly in order to provide the semiconductor device 10 with a protective, electrically insulating encapsulation.

Manufacturing processes for obtaining a semiconductor device 10 as illustrated in Figure 1 are conventional in the art which makes it unnecessary to provide a more detailed discussion herein.

A semiconductor device 10 as illustrated in Figure 1 is configured to be mounted on a support such as a printed circuit board (PCB), for instance. To that effect, solder material (tin, for instance) may be provided at the bottom surface of the die pad 12A.

Figures 2 and 3 (wherein Figure 3 is an enlarged view of the portion of Figure 2 indicated by the arrow III) illustrate the bottom surface of a die pad 12A of a (IC) semiconductor device such as the device 10 illustrated in Figure 1.

As illustrated, a molding step as mentioned in the foregoing may undesirably result in some leaks of molding compound 20 (oftentimes referred to as molding/resin flashes) covering the bottom surface of the of the die pad 12A, at the peripheral region thereof.

In order to counter the undesired resin flashes from covering a more extended portion of the bottom surface of the die pad 12A, grooves G are provided at the bottom surface of the die pad 12A. In the examples illustrated in Figures 2 and 3 two grooves G are provided as trenches running along the periphery of the die mounting location 120A, close to its edge, to contain resin flashes.

Resin flashes may cause inadequate plating of solder material on the bottom surface of the die pad 12A and, consequently, may give rise to issues related to mounting/soldering on the final substrate (a PCB, for instance).

Moreover, it is observed that resin flashes as illustrated, for instance, in Figure 3, may cause so-called "tin islands" (where the reference to tin is merely due to a commonly used solder material) to form. These are small amounts of soldering material that is plated in regions of the bottom surface of the die pad 12A (at the periphery thereof, for instance) left uncovered by the molding compound 20 leaks; these "lumps" of soldering material are prone to detach from the die pad 12A (during processing, for instance) possibly causing undesired short circuits between the leads 12B, for instance, thus causing failure of the device.

According to a conventional approach, issues related to such molding flashes may be countered via so-called de-flashing processes that involve removing resin flashes formed at the bottom surface of the die pad 12A. However, de-flashing processes such as chemical or dry de-flashing processes may undesirably reduce adhesion of the molding compound 20 to the metallic (copper, for instance) leadframe possibly causing delamination of the molding compound 20.

Delamination of the molding compound 20 from the die pad 12A or lead 12B may cause humidity or contaminants to enter the package possibly reaching the semiconductor die 14 and causing failure of the device 10.

Moreover, delamination caused by chemical de-flashing may be more severe when adhesion promoters (such as non-etching adhesion promoters, NEAP) are used to enhance adhesion between the molding compound 20 and the leadframe 12A, 12B.

Figure 4 is an enlarged view of the portion of Figure 1 indicated by the arrow IV that illustrates an adhesion promoter (NEAP, for instance) layer 100 provided at the interface between the molding compound 20 and the leadframe 12A, 12B.

The adhesion promoter layer 100 may be at least partly dissolved when devices 10 are processed in a de-flashing bath, possibly causing delamination issues. It is observed that delamination is more likely to start at a line D, that is the points at the interface between the die pad 12A and the molding compound 20 that are exposed to a de-flashing bath.

According to another conventional approach, a dry de-flashing process can be used to remove molding compound flashes at the bottom surface of the die pad 12A.

Dry de-flashing may involve applying laser beam energy to the bottom surface of the die pad 12A to remove the undesired resin flashes via laser ablation.

However, in order to counter undesired ablation of molding compound of the package, laser ablation does not conventionally extend to the edge of the back/bottom surface of the die pad 12A exposed at the bottom of the device 10.

In other words, laser beam energy is not applied to a "safety" zone S (of about 100 microns, for instance) at the periphery of the back/bottom surface of the die pad 12A exposed at the bottom surface of the device 10 (on the right of the interface line D in Figure 4) in order not to undesirably ablate molding compound 20 forming the electrically insulating encapsulation (on the left of the interface line D in Figure 4).

Solutions as described herein involve applying laser beam energy to the bottom surface of a die pad to form therein a recessed portion that is subsequently filled with electrically insulating material during molding.

In solutions as described herein, a roughened surface may be formed at the recessed portion of the die pad that enhances adhesion between the molding compound and the die pad.

In solutions as described herein, an adhesion promoter layer possibly provided at the bottom surface of the die pad is removed at the recessed portion thereof via laser ablation, prior to molding an electrically insulating encapsulation.

Solutions as described herein may advantageously be applied to (integrated circuit) semiconductor devices provided with an exposed pad quad flat package (QFP) as the semiconductor device 10 illustrated in Figure 1, for instance.

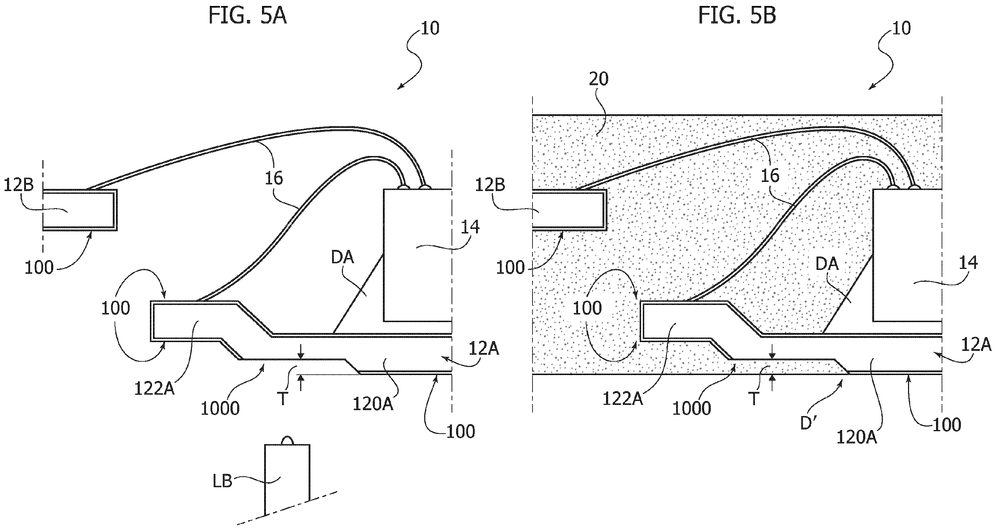

Figures 5A and 5B are illustrative of processing steps according to embodiments of the present description applied to a semiconductor device such as the semiconductor device 10 exemplified in Figure 1.

As known to those skilled in the art, a plurality of semiconductor devices (such as the semiconductor device 10 illustrated in Figure 1) can be concurrently processed by providing a common substrate (such as a leadframe reel or panel, for instance) comprising a plurality of individual substrates/leadframes. Individual leadframes may be held together via connecting bars (or dam bar) running around the periphery of each (individual) leadframe. A final singulation step removes the connecting bars (dam bars) to obtain a plurality of individual semiconductor devices.

For simplicity and ease of explanation, the following description will refer to manufacturing a single device.

It will be appreciated that the details of the structure of a device 10 as discussed herein are merely exemplary of a device where solutions as described herein may advantageously be applied, and shall not be construed in a limiting sense.

For instance, those skilled in the art may appreciate that solutions as described herein may be applied, for instance, also in case of other packages having an exposed die pad such as quad flat no leads packages (QFN) and/or to leadframes having no downset between the die pad 12A and the leads 12B and/or to die pads 12A not having a raised rim 122A.

Figure 5A is illustrative of a semiconductor die 14 mounted (via die attach material DA, for instance) at the top/front surface of a die pad 12A, at a die mounting region 120A thereof.

As illustrated, laser beam energy LB is applied to the back/bottom surface of the die pad 12A, at the periphery of the bottom surface of the die pad 12A to form therein a recessed portion 1000. That is, metallic material (copper, for instance) of the die pad 12A is removed from the back/bottom surface thereof via laser ablation to form a recessed portion 1000 along the periphery of the back/bottom surface of the die pad 12A.

As illustrated, the recessed peripheral portion 1000 surrounds a central portion of the back/bottom surface that is opposite of the die mounting region 120A at the front/top surface of the die pad 12A.

The recessed peripheral portion 1000 of the back/bottom surface of the die pad 12A may be formed with a depth, indicated with the reference T in Figure 5A, in the range of 25 to 35 microns, for instance.

In exemplary case illustrated in Figure 5A, an adhesion promoter layer (a NEAP layer, for instance) is provided on the surface of the leadframe (that is, the die pad 12A and the leads 12B), both at the top/front and back/bottom surfaces of the leadframe, as illustrated in Figure 5A.

As illustrated, applying laser beam energy LB to form the peripheral recessed region 1000 of the back/bottom surface of the die pad 12A results in the adhesion promoter layer 100 being removed (ablated) at the peripheral recessed region 1000.

Said otherwise, the recessed peripheral portion of the second surface of the die pad 12A is exempt from the adhesion promoter layer 100 in response to the laser beam energy LB applied thereto.

Figure 5B is illustrative of a molding step where an electrically insulating encapsulation material 20 (such as an epoxy resin, for instance) is molded onto the substrate (a leadframe, for instance) 12A, 12B having a semiconductor die 14 mounted thereon, subsequently to forming the recessed portion 1000 as described in the foregoing.

As illustrated, the (electrically insulating) molding compound 20 fills the recessed peripheral portion 1000 of the back/bottom surface of the die pad 12A thus forming a layer (having a thickness notionally equal to the depth T of the recessed portion 1000) of encapsulation material 20 that covers the back/bottom surface of the die pad 12A at the recessed portion 1000.

Said otherwise, subsequently to the molding step, the bottom surface of a device 10 comprises:
a central, inner region of the bottom surface of the die pad 12A (inwardly of the border line D') where the metallic material of the die pad 12A is not covered by the encapsulation material 20, and
a peripheral, outer region of the bottom surface of the die pad 12A, that is, the peripheral recessed portion 1000, where the metallic material of the die pad 12A is covered by encapsulation material 20.

As illustrated, in devices where the die pad 12A comprises a raised rim 122A around the die mounting region 120A, the peripheral rim 122A is embedded in the encapsulation material 20.

It is observed that a peripheral recessed region 1000 formed at the die mounting region 120A counters undesired leakage of molding material over the central portion of the back/bottom surface of the die pad 12A.

As mentioned, the recessed peripheral portion 1000 of the back/bottom surface of the die pad 12A may be formed with a depth, in the range of 25 to 35 microns, for instance.

Relatively shallow recessed peripheral portions 1000, having a depth, for instance, between 2 and 3 microns, may also be formed that have been observed to give satisfactory results in terms of countering undesired leakage of molding material over the central portion of the back/bottom surface of the die pad 12A.

It is noted that a de-flashing step (a per se conventional de-flashing step such as chemical de-flashing step, for instance) may be performed subsequent to the molding step.

It is observed that such a de-flashing step does not completely remove the (electrically insulating) molding compound 20 that fills the recessed peripheral portion 1000 also in embodiments where the layer of encapsulation material 20 at the recessed portion 1000 has a thickness between 2 and 3 microns. Said otherwise, a de-flashing step leaves the die pad 12A material (copper, for instance) at the recessed peripheral portion 1000 covered with a layer of encapsulation material 20 (possibly with a thickness between 2 and 3 microns) .

Moreover, applying laser beam energy LB to form a peripheral recessed portion 1000 as illustrated in the figures, has the effect of roughening the back/bottom surface of the die mounting region 120A at the peripheral recessed portion 1000.

As used herein, according to common usage, a surface being "roughened" indicates that such a surface is made rough.

A rough surface has been found to promote adhesion between the encapsulation material 20 and the die pad 12A, thus reducing the risk of delamination.

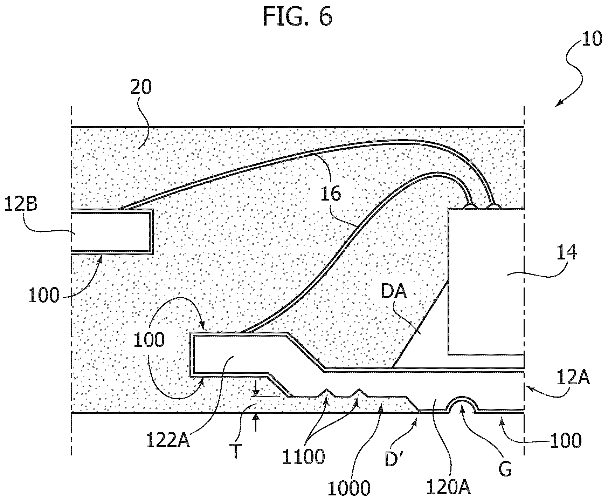

In summary, solutions as described herein in relation to Figures 5A, 5B and 6, involve molding an encapsulation 20 of electrically insulating material (an epoxy resin, for instance) onto a substrate (such as a leadframe comprising die pad 12A and leads 12B) having at (least one) semiconductor die 14 arranged thereon.

As illustrated in the figures, the semiconductor die 14 is arranged at a die mounting region 120A at a first (top/front) surface of a die pad 12A in the substrate, wherein the die pad 12A having a second (bottom/back) surface opposite the first surface.

Laser beam energy LB is applied to the second surface of the die pad 12A to form therein a recessed peripheral portion 1000 (preferably, having a depth between 25 and 35 microns) surrounding a central portion opposite the die mounting region 120A at the first surface.

During molding the electrically insulating material 20 covers the recessed peripheral portion 1000 and leakage of the electrically insulating material 20 over said central portion is countered in response to the peripheral portion 1000 of the second surface of the die pad 12A being recessed.

Advantageously, the recessed peripheral portion 1000 of the second surface of the die pad 12A is roughened in response to laser beam energy LB applied thereto, thus facilitating adhesion of the electrically insulating material 20 to the recessed peripheral portion.

Figure 6 illustrates embodiments of the present description wherein adhesion between metallic material of the die pad 12A and the molding compound 20 may be further facilitated at peripheral recessed portion 1000 of the die mounting portion by forming (via laser ablation LB) therein sculpturing 1100 - such as notches or trenches 1100 running along the recessed peripheral portion 1000.

Figure 6 also illustrates that the peripheral recessed portion 1000 may be provided at the back/bottom surface of the die pad 12A in addition to (otherwise conventional) grooves G thus further reducing the risk of resin leaks undesirably covering the central portion of the second surface of the die pad 12A.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
providing an adhesion promoter layer (100) on first and second opposite surfaces of a die pad (12A) in a substrate (12A, 12B),
molding an encapsulation (20) of electrically insulating material onto the substrate (12A, 12B) having at least one semiconductor die (14) arranged thereon at a die mounting region (120A) of the first surface of the die pad (12A) in the substrate (12A, 12B),
wherein the method comprises applying laser beam energy (LB) to the second surface of the die pad (12A) to form in the second surface of the die pad (12A) a recessed peripheral portion (1000) surrounding a central portion, said central portion of the second surface of the die pad (12A) being opposite the die mounting region (120A) at the first surface, wherein applying laser beam energy (LB) to form the recessed peripheral portion (1000) of the second surface of the die pad (12A) comprises removing said adhesion promoter layer (100) therefrom, and wherein during said molding the electrically insulating material (20) covers said recessed peripheral portion (1000) with leakage of the electrically insulating material (20) over said central portion being countered in response to the peripheral portion (1000) of the second surface of the die pad (12A) being recessed.

2. The method of claim 1, wherein the recessed peripheral portion (1000) of the second surface of the die pad (12A) has a depth in the range 25 to 35 microns.

3. The method of claim 1 or claim 2, wherein the recessed peripheral portion (1000) of the second surface of the die pad (12A) is roughened in response to laser beam energy (LB) applied thereto, wherein adhesion of the electrically insulating material (20) to said recessed peripheral portion (1000) is facilitated.

4. The method of any of claims 1 to 3, wherein the die pad (12A) comprises a raised rim (122A) around the die mounting region (120A) at the first surface of the die pad (12A), wherein said raised rim (122A) is embedded in the electrically insulating material (20) during said molding.

5. The method of any of the previous claims, comprising forming sculpturing (1100) at the recessed peripheral portion (1000) of the second surface of the die pad (12A), wherein adhesion of the electrically insulating material (20) to said recessed peripheral portion (1000) is facilitated by said sculpturing (1100).

6. The method of any of the previous claims, comprising providing grooves (G) at the central portion of the second surface of the die pad (12A).

7. A device (10), comprising:
an adhesion promoter layer (100) provided on first and second opposite surfaces of a die pad (12A) in a substrate (12A, 12B),
an encapsulation (20) of electrically insulating material molded onto the substrate (12A, 12B) having at least one semiconductor die (14) arranged thereon at a die mounting region (120A) of the first surface of the die pad (12A) in the substrate (12A, 12B), and
a recessed peripheral portion (1000) formed via laser beam energy (LB) applied to the second surface of the die pad (12A), the recessed peripheral portion (1000) surrounding a central portion opposite the die mounting region (120A) at the first surface, wherein said recessed peripheral portion of the second surface of the die pad (12A) is exempt from the adhesion promoter layer (100) in response to the laser beam energy (LB) applied thereto,
wherein the electrically insulating material (20) covers said recessed peripheral portion (1000) with leakage of the electrically insulating material (20) over said central portion countered in response to the peripheral portion of the second surface of the die pad (12A) being recessed.

8. The device (10) of claim 7, wherein the recessed peripheral portion (1000) of the second surface of the die pad (12A) has a depth in the range 25 to 35 microns.

9. The device (10) of claim 7 or claim 8, wherein the recessed peripheral portion (1000) of the second surface of the die pad (12A) is roughened, with the electrically insulating material (20) adhering to said roughened surface.

10. The device (10) of any of claims 7 to 9, wherein the die pad (12A) comprises a raised rim (122A) around the die mounting region (120A) at the first surface of the die pad (12A), wherein said raised rim (122A) is embedded in the electrically insulating material (20).

11. The device (10) of any of claims 7 to 10, comprising sculpturing (1100) formed at the recessed peripheral portion (1000) of the second surface of the die pad (12A).

12. The device (10) of any of claims 7 to 11, comprising grooves (G) provided at the central portion of the second surface of the die pad (12A).

## Patentansprüche

1. Verfahren, umfassend:
Bereitstellen einer Haftvermittlerschicht (100) auf ersten und zweiten gegenüberliegenden Oberflächen einer Chip-Kontaktfläche (12A) in einem Substrat (12A, 12B),
Formen einer Einkapselung (20) aus elektrisch isolierendem Material auf das Substrat (12A, 12B), wobei mindestens ein Halbleiterchip (14) in einem Chip-Montagebereich (120A) der ersten Oberfläche der Chip-Kontaktfläche (12A) im Substrat (12A, 12B) darauf angeordnet ist,
wobei das Verfahren das Anwenden von Laserstrahlenergie (LB) auf die zweite Oberfläche der Chip-Kontaktfläche (12A) umfasst, um in der zweiten Oberfläche der Chip-Kontaktfläche (12A) einen vertieften peripheren Abschnitt (1000) zu bilden, der einen mittleren Abschnitt umgibt,
wobei der mittlere Abschnitt der zweiten Oberfläche der Chip-Kontaktfläche (12A) dem Chip-Montagebereich (120A) an der ersten Oberfläche gegenüberliegt, wobei das Anwenden von Laserstrahlenergie (LB) zum Bilden des vertieften peripheren Abschnitts (1000) der zweiten Oberfläche der Chip-Kontaktfläche (12A) das Entfernen der Haftvermittlerschicht (100) davon umfasst, und wobei das elektrisch isolierende Material (20) während des Formens den vertieften peripheren Abschnitt (1000) abdeckt, wobei einem Auslaufen des elektrisch isolierenden Materials (20) über den mittleren Abschnitt in Reaktion dahingehend entgegengewirkt wird, dass der vertiefte periphere Abschnitt (1000) der zweiten Oberfläche der Chip-Kontaktfläche (12A) vertieft ist.

2. Verfahren nach Anspruch 1, wobei der vertiefte periphere Abschnitt (1000) der zweiten Oberfläche der Chip-Kontaktfläche (12A) eine Tiefe im Bereich von 25 bis 35 Mikrometer aufweist.

3. Verfahren nach Anspruch 1 oder Anspruch 2, wobei der vertiefte periphere Abschnitt (1000) der zweiten Oberfläche der Chip-Kontaktfläche (12A) als Reaktion auf die darauf angewandte Laserstrahlenergie (LB) aufgeraut wird, wobei die Haftung des elektrisch isolierenden Materials (20) an dem vertieften peripheren Abschnitt (1000) erleichtert wird.

4. Verfahren nach einem der Ansprüche 1 bis 3, wobei die Chip-Kontaktfläche (12A) einen erhabenen Rand (122A) um den Chip-Montagebereich (120A) herum an der ersten Oberfläche der Chip-Kontaktfläche (12A) umfasst, wobei der erhabene Rand (122A) während des Formens in das elektrisch isolierende Material (20) eingebettet wird.

5. Verfahren nach einem der vorhergehenden Ansprüche, umfassend das Formen einer Strukturierung (1100) am vertieften peripheren Abschnitt (1000) der zweiten Oberfläche der Chip-Kontaktfläche (12A), wobei die Haftung des elektrisch isolierenden Materials (20) an dem vertieften peripheren Abschnitt (1000) durch die Strukturierung (1100) erleichtert wird.

6. Verfahren nach einem der vorhergehenden Ansprüche, umfassend das Bereitstellen von Rillen (G) am mittleren Abschnitt der zweiten Oberfläche der Chip-Kontaktfläche (12A).

7. Vorrichtung (10), die Folgendes umfasst:
eine Haftvermittlerschicht (100), die auf ersten und zweiten gegenüberliegenden Oberflächen einer Chip-Kontaktfläche (12A) in einem Substrat (12A, 12B) bereitgestellt ist,
eine Einkapselung (20) aus elektrisch isolierendem Material, das auf das Substrat (12A, 12B) geformt ist,
wobei mindestens ein Halbleiterchip (14) in einem Chip-Montagebereich (120A) der ersten Oberfläche der Chip-Kontaktfläche (12A) im Substrat (12A, 12B) darauf angeordnet ist, und
einen vertieften peripheren Abschnitt (1000), der durch Laserstrahlenergie (LB) ausgebildet wird, die auf die zweite Oberfläche des Werkzeugpolsters (12A) angewandt wird, wobei der vertiefte periphere Abschnitt (1000) einen mittleren Abschnitt gegenüber dem Chip-Montagebereich (120A) an der ersten Oberfläche umgibt, wobei der vertiefte periphere Abschnitt der zweiten Oberfläche der Chip-Kontaktfläche (12A) als Reaktion auf die darauf angewandte Laserstrahlenergie (LB) von der Haftvermittlerschicht (100) befreit ist,
wobei das elektrisch isolierende Material (20) den vertieften peripheren Abschnitt (1000) abdeckt, wobei einem Auslaufen des elektrisch isolierenden Materials (20) über den mittleren Abschnitt in Reaktion dahingehend entgegengewirkt wird, dass der vertiefte periphere Abschnitt der zweiten Oberfläche der Chip-Kontaktfläche (12A) vertieft ist.

8. Vorrichtung (10) nach Anspruch 7, wobei der vertiefte periphere Abschnitt (1000) der zweiten Oberfläche der Chip-Kontaktfläche (12A) eine Tiefe im Bereich von 25 bis 35 Mikrometer aufweist.

9. Vorrichtung (10) nach Anspruch 7 oder Anspruch 8, wobei der vertiefte periphere Abschnitt (1000) der zweiten Oberfläche der Chip-Kontaktfläche (12A) aufgeraut ist, wobei das elektrisch isolierende Material (20) an der aufgerauten Oberfläche haftet.

10. Vorrichtung (10) nach einem der Ansprüche 7 bis 9, wobei die Chip-Kontaktfläche (12A) einen erhabenen Rand (122A) um den Chip-Montagebereich (120A) herum an der ersten Oberfläche der Chip-Kontaktfläche (12A) umfasst, wobei der erhabene Rand (122A) in das elektrisch isolierende Material (20) eingebettet wird.

11. Vorrichtung (10) nach einem der Ansprüche 7 bis 10, umfassend eine Strukturierung (1100), die an dem vertieften peripheren Abschnitt (1000) der zweiten Oberfläche der Chip-Kontaktfläche (12A) ausgebildet ist.

12. Vorrichtung (10) nach einem der Ansprüche 7 bis 11, umfassend Rillen (G), die am mittleren Abschnitt der zweiten Oberfläche der Chip-Kontaktfläche (12A) vorgesehen sind.

## Revendications

1. Procédé comprenant les étapes suivantes :
fournir une couche d'adhérence (100) sur des première et deuxième surfaces opposées d'une pastille de puce (12A) dans un substrat (12A, 12B),
mouler une encapsulation (20) en matériau électriquement isolant sur le substrat (12A, 12B) sur lequel est placée au moins une puce de semiconducteur (14) dans une région de montage de puce (120A) de la première surface de la pastille de puce (12A) dans le substrat (12A, 12B),
dans lequel le procédé comprend l'application d'une énergie de faisceau laser (LB) sur la deuxième surface de la pastille de puce (12A) afin de former dans la deuxième surface de la pastille de puce (12A) une partie périphérique évidée (1000) entourant une partie centrale, ladite partie centrale de la deuxième surface de la pastille de puce (12A) se trouvant en face de la région de montage de puce (120A) de la première surface, dans lequel l'application d'une énergie de faisceau laser (LB) pour former la partie périphérique évidée (1000) de la deuxième surface de la pastille de puce (12A) comprend le fait de supprimer ladite couche d'adhérence (100) de cette dernière, et dans lequel pendant ledit moulage, le matériau électriquement isolant (20) couvre ladite partie périphérique évidée (1000) et la fuite du matériau électriquement isolant (20) sur ladite partie centrale est empêchée en raison de la nature évidée de la partie périphérique (1000) de la deuxième surface de la pastille de puce (12A).

2. Procédé selon la revendication 1, dans lequel la partie périphérique évidée (1000) de la deuxième surface de la pastille de puce (12A) a une profondeur comprise dans l'intervalle de 25 à 35 micromètres.

3. Procédé selon la revendication 1 ou 2, dans lequel la partie périphérique évidée (1000) de la deuxième surface de la pastille de puce (12A) est rendue rugueuse par l'application d'une énergie de faisceau laser (LB) sur celle-ci, dans lequel l'adhésion du matériau électriquement isolant (20) à ladite partie périphérique évidée (1000) est facilitée.

4. Procédé selon l'une quelconque des revendications 1 à 3, dans lequel la pastille de puce (12A) comprend un bord relevé (122A) autour de la région de montage de puce (120A) au niveau de la première surface de la pastille de puce (12A), dans lequel ledit bord relevé (122A) est noyé dans le matériau électriquement isolant (20) pendant ledit moulage.

5. Procédé selon l'une quelconque des revendications précédentes, comprenant la formation de sculptures (1100) dans la partie périphérique évidée (1000) de la deuxième surface de la pastille de puce (12A), dans lequel l'adhésion du matériau électriquement isolant (20) à ladite partie périphérique évidée (1000) est facilitée par lesdites sculptures (1100).

6. Procédé selon l'une quelconque des revendications précédentes, comprenant le fait de prévoir des rainures (G) dans la partie centrale de la deuxième surface de la pastille de puce (12A).

7. Dispositif (10) comprenant :
une couche d'adhérence (100) placée sur des première et deuxième surfaces opposées d'une pastille de puce (12A) dans un substrat (12A, 12B),
une encapsulation (20) en matériau électriquement isolant moulée sur le substrat (12A, 12B) sur lequel est placée au moins une puce de semiconducteur (14) dans une région de montage de puce (120A) de la première surface de la pastille de puce (12A) dans le substrat (12A, 12B), et
une partie périphérique évidée (1000) formée au moyen d'une énergie de faisceau laser (LB) appliquée sur la deuxième surface de la pastille de puce (12A), la partie périphérique évidée (1000) entourant une partie centrale se trouvant en face de la région de montage de puce (120A) de la première surface, dans lequel ladite partie périphérique évidée de la deuxième surface de la pastille de puce (12A) est exempte de la couche d'adhérence (100) en raison de l'énergie de faisceau laser (LB) qui lui est appliquée,
dans lequel le matériau électriquement isolant (20) couvre ladite partie périphérique évidée (1000) et la fuite du matériau électriquement isolant (20) sur ladite partie centrale est empêchée en raison de la nature évidée de la partie périphérique de la deuxième surface de la pastille de puce (12A).

8. Dispositif (10) selon la revendication 7, dans lequel la partie périphérique évidée (1000) de la deuxième surface de la pastille de puce (12A) a une profondeur comprise dans l'intervalle de 25 à 35 micromètres.

9. Dispositif (10) selon la revendication 7 ou 8, dans lequel la partie périphérique évidée (1000) de la deuxième surface de la pastille de puce (12A) est rendue rugueuse, dans lequel le matériau électriquement isolant (20) adhère à ladite surface rugueuse.

10. Dispositif (10) selon l'une quelconque des revendications 7 à 9, dans lequel la pastille de puce (12A) comprend un bord relevé (122A) autour de la région de montage de puce (120A) au niveau de la première surface de la pastille de puce (12A), dans lequel ledit bord relevé (122A) est noyé dans le matériau électriquement isolant (20).

11. Dispositif (10) selon l'une quelconque des revendications 7 à 10, comprenant des sculptures (1100) formées dans la partie périphérique évidée (1000) de la deuxième surface de la pastille de puce (12A).

12. Dispositif (10) selon l'une quelconque des revendications 7 à 11, comprenant des rainures (G) formées dans la partie centrale de la deuxième surface de la pastille de puce (12A).
